# EUROPEAN PATENT APPLICATION

(11) **EP 3 896 740 A1**
(43) Date of publication of application: **20.10.2021**
(21) Application number: 19902598.2
(22) Date of filing: 13.12.2019
(51) Int. Cl.: H01L 27/32, H01L 51/52, H01L 51/56

(54) **OLED PIXEL STRUCTURE, OLED DISPLAY SCREEN AND ELECTRONIC DEVICE**

(30) Priority: 29.12.2018 CN 201822274111 U; 29.12.2018 CN 201811653791
(71) Applicant: GUANGDONG OPPO MOBILE TELECOMMUNICATIONS CORP., LTD., Dongguan, Guangdong 523860 (CN)
(72) Inventor: ZHENG, Yicheng, Dongguan, Guangdong 523860 (CN); YANG, Bo, Dongguan, Guangdong 523860 (CN)
(74) Representative: Taor, Simon Edward William
(86) International application number: PCT/CN2019/125273
(87) International publication number: WO 2020/135107

(57) **Abstract**

Disclosed is an OLED pixel structure (1), comprising a substrate (11), and a first electrode (12), a pixel layer (13) and a second electrode (14) successively arranged on the substrate (11) in a stacked manner, wherein the pixel layer (13) comprises a plurality of pixel points arranged in an array; a gap (137) is formed between two adjacent pixel points; the first electrode (12) and the second electrode (14) are arranged, in a hollowed-out manner, at a position corresponding to the gap (137); the OLED pixel structure (1) further comprises an isolation column (15); part of the isolation column (15) is accommodated in the gap (137); the isolation column (15) is provided with a first end face (153) and a second end face (155) arranged opposite each other; the first end face (153) faces the substrate (11), and the second end face (155) faces away from the substrate (11); and the isolation column (15) is used to transmit an optical signal and allow the optical signal to pass in from one of the first end face (153) and the second end face (155) and out from the other end face. Further provided are an OLED display screen (10) and an electronic device (100). The isolation column (15) transmits the optical signal and allows the optical signal to pass in from one of the first end face (153) and the second end face (155) and out from the other end face, thereby avoiding signal interference and effectively improving optical signal-to-noise ratio.

## Description

### FIELD

The present disclosure relates to the field of organic light-emitting diode (OLED) display, and particularly to an OLED pixel structure, an OLED display screen, and an electronic device.

### BACKGROUND

Currently, a difficulty in application of under-screen optical detection technologies such as under-screen optical sensing technology is that: optical sensors are disposed under an organic light-emitting diode (OLED) display screen, and optical signals need to pass through gaps between red (R)/green (G)/blue (B) pixel points and isolation columns of the OLED display screen to be received by the light sensors. However, regardless of visible light or infrared light, only a very small amount of the light signals can be received. In addition, when the pixel points of the OLED display screen emit light, a part of the light is scattered and reflected, and leaks to the optical sensors through the gaps between the R/G/B pixel points and the isolation columns. These result in a reduction in optical signal-to-noise ratio, and affect user experience.

### SUMMARY

The present disclosure provides an organic light-emitting diode (OLED) pixel structure, an OLED display screen, and an electronic device, which can effectively improve optical signal-to-noise ratios to solve the above technical problems.

The OLED pixel structure provided by the present disclosure comprises a substrate, a first electrode, a pixel layer, and a second electrode that are sequentially stacked, and an isolation column. The pixel layer comprises a plurality of pixel points disposed in an array. Two adjacent pixel points cooperatively define a gap therebetween. Parts of the first electrode and the second electrode corresponding to the gap are hollowed out. A part of the isolation column is accommodated in the gap. The isolation column comprises a first end surface and a second end surface disposed oppositely. The first end surface faces the substrate, and the second end surface faces away from the substrate. The isolation column is configured to transmit an optical signal, and is configured to allow the optical signal to pass in from one of the first end surface and the second end surface and pass out from the other end surface.

The OLED display screen provided by the present disclosure comprises an OLED pixel structure and a cover plate. The OLED pixel structure comprises a substrate, a first electrode, a pixel layer, and a second electrode that are sequentially stacked, and an isolation column. The pixel layer comprises a plurality of pixel points disposed in an array. Two adjacent pixel points cooperatively define a gap therebetween. Parts of the first electrode and the second electrode corresponding to the gap are hollowed out. A part of the isolation column is accommodated in the gap. The isolation column comprises a first end surface and a second end surface disposed oppositely. The first end surface faces the substrate, and the second end surface faces away from the substrate. The isolation column is configured to transmit an optical signal, and is configured to allow the optical signal to pass in from one of the first end surface and the second end surface and pass out from the other end surface. The cover plate is disposed on a side of the substrate away from the pixel layer.

The electronic device provided by the present disclosure comprises an OLED display screen, an optical sensor, and a processor. The OLED display screen comprises an OLED pixel structure and a cover plate. The OLED pixel structure comprises a substrate, a first electrode, a pixel layer, and a second electrode that are sequentially stacked, and an isolation column. The pixel layer comprises a plurality of pixel points disposed in an array. Two adjacent pixel points cooperatively define a gap therebetween. Parts of the first electrode and the second electrode corresponding to the gap are hollowed out. A part of the isolation column is accommodated in the gap. The isolation column comprises a first end surface and a second end surface disposed oppositely. The first end surface faces the substrate, and the second end surface faces away from the substrate. The isolation column is configured to transmit an optical signal, and is configured to allow the optical signal to pass in from one of the first end surface and the second end surface and pass out from the other end surface. The cover plate is disposed on a side of the substrate away from the pixel layer. The optical sensor is disposed on a side of the isolation column away from the substrate. The isolation column is further configured to guide the optical signal to the optical sensor. The optical sensor is configured to receive the optical signal transmitted through the isolation column and convert the optical signal into an electrical signal. The processor is configured to determine characteristic information carried by the optical signal according to the electrical signal.

In the OLED pixel structure, the OLED display screen, and the electronic device of the present disclosure, the isolation column of the OLED pixel structure comprises the first end surface and the second end surface disposed oppositely, the first end surface faces the substrate, and the second end surface faces away from the substrate. The isolation column is configured to transmit an optical signal, and is configured to allow the optical signal to pass in from one of the first end surface and the second end surface and pass out from the other end surface. The isolation column is further configured to guide the optical signal to the optical sensor. The optical sensor is configured to receive the optical signal transmitted through the isolation column and convert the optical signal into an electrical signal. The processor is configured to determine characteristic information carried by the optical signal according to the electrical signal. Therefore, optical signal interference caused by other light can be effectively prevented, and optical signal-to-noise ratios can be effectively improved.

### BRIEF DESCRIPTION OF DRAWINGS

In order to more clearly illustrate technical solutions in embodiments of the present disclosure, a brief description of accompanying drawings used in the embodiments will be given below. It is obvious that the accompanying drawings in the following description are merely some embodiments of the present disclosure. For those skilled in the art, other drawings may be obtained from these accompanying drawings without creative labor.
FIG. 1 is a schematic block diagram of an electronic device according to an embodiment of the present disclosure.
FIG. 2 is a schematic structural diagram of a part of a structure of the electronic device according to an embodiment of the present disclosure.
FIG. 3 is a schematic structural diagram of the part of the structure of the electronic device according to another embodiment of the present disclosure.
FIG. 4 is a schematic structural diagram of the part of the structure of the electronic device according to an additional embodiment of the present disclosure.

### DETAILED DESCRIPTION

In order to enable those skilled in the art to better understand solutions of the present disclosure, technical solutions in embodiments of the present disclosure will be clearly described below in conjunction with accompanying drawings in the embodiments of the present disclosure. Apparently, the described embodiments are merely some of the embodiments of the present disclosure and not all embodiments. All other embodiments obtained by those skilled in the art based on the embodiments of the present disclosure without creative labor are within the claimed scope of the present disclosure.

Terms "first", "second", and the like used in the specification, the claims, and the accompanying drawings of the present disclosure are used to distinguish different objects rather than describe a particular order. A term "comprise" and its variations are intended to cover a non-exclusive inclusion. For example, a process, method, system, product, or apparatus including a series of steps or units is not limited to the listed steps or units, and may optionally include other steps or units that are not listed, or other steps or units inherent to the process, method, product, or device.

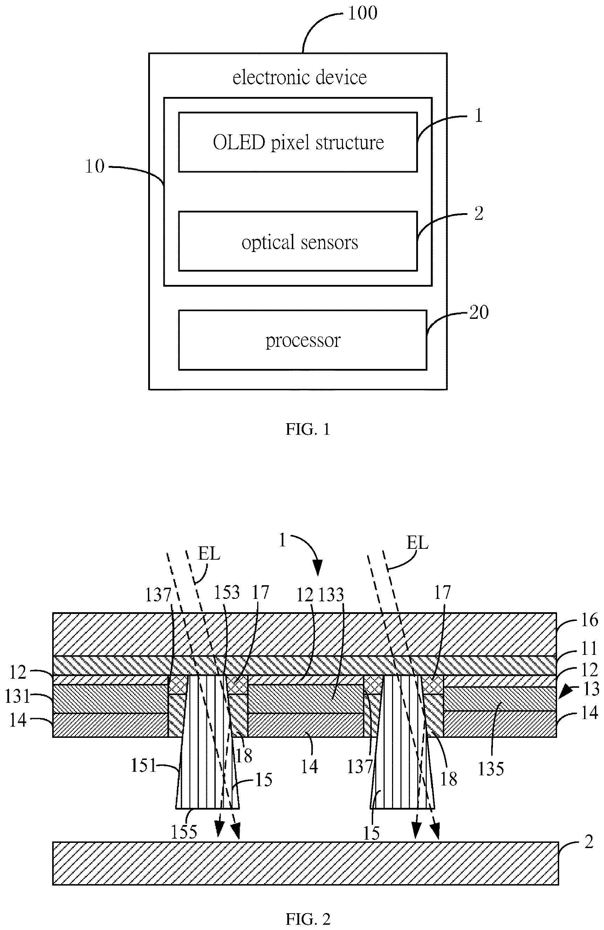

Please refer to FIG. 1, which is a schematic block diagram of an electronic device 100 according to an embodiment of the present disclosure. The electronic device 100 may be, but is not limited to, a terminal device with a display screen, such as a mobile phone, a tablet computer, an e-reader, and a wearable electronic device.

The electronic device 100 comprises an organic light-emitting diode (OLED) display screen 10. It can be understood that FIG. 1 is only an example of the electronic device 100 and does not constitute a limitation on the electronic device 100. The electronic device 100 may comprise more or fewer components than those shown in FIG. 1, or a combination of some components, or different components. For example, the electronic device 100 may also comprise an input/output device, a network access device, a data bus, and the like.

The OLED display screen 10 comprises a plurality of OLED pixel structures 1disposed in sequence. Specifically, please refer to FIG. 2, the OLED pixel structure 1 comprises a substrate 11, a first electrode 12, a pixel layer 13, and a second electrode 14 that are sequentially stacked, and a plurality of isolation columns 15. The pixel layer 13 comprises a plurality of pixel points disposed in an array. Every two adjacent pixel points cooperatively define a gap 137 therebetween. Parts of the first electrode 12 and the second electrode 14 corresponding to the gap 137 are hollowed out. A part of each of the isolation columns 15 is accommodated in a corresponding gap 137. Each of the isolation columns 15 comprises a first end surface 153 and a second end surface 155 disposed oppositely. The first end surface 153 faces the substrate 11, and the second end surface 155 faces away from the substrate 11. Each of the isolation columns 15 is configured to transmit optical signals, and is configured to allow the optical signals to pass in from one of the first end surface 153 and the second end surface 155 and pass out from the other end surface.

Current isolation columns are opaque, so that external light only passes through gaps between the isolation columns and the corresponding pixel points. However, in the present disclosure, each of the isolation columns 15 is configured to transmit optical signals, and is configured to allow the optical signals to pass in from one of the first end surface 153 and the second end surface 155 and pass out from the other end surface. Therefore, external light EL may pass through interiors of the isolation columns 15 from the first end surfaces 153 of the isolation columns 15, and then pass out from the second end surfaces 155 of the isolation columns 15. Alternatively, internal light may pass through the interiors of the isolation columns 15 from the second end surfaces 155 of the isolation columns 15, and then pass out from the first end surfaces 153 of the isolation columns 15. Accordingly, interference caused by other light on sensing of optical signals can be effectively avoided, and optical signal-to-noise ratios can be effectively improved.

Specifically, in an embodiment, the parts of the first electrode 12 and the second electrode 14 corresponding to the gap 137 are hollowed out, which means that the parts of the first electrode 12 and the second electrode 14 corresponding to the gap 137 are empty and are not filled with material.

Specifically, in an embodiment, the substrate 11 is a glass substrate. It can be understood that, in other embodiments, the substrate 11 may also be a substrate made of other materials, which is not limited herein.

Specifically, in an embodiment, the first electrode 12 is an anode, i.e., a common electrode, and is made of indium tin oxide.

Specifically, in an embodiment, the second electrode 14 is a cathode.

Specifically, in an embodiment, each of the isolation columns 15 further comprises an outer side surface 151 disposed along its periphery. The outer side surface 151 connects the first end surface 153 and the second end surface 155. The outer side surfaces 151 of the isolation columns are opaque, and interiors, the first end surfaces, and the second end surfaces of the isolation columns are transparent.

It can be understood that, in an embodiment, the outer side surfaces 151 of the isolation columns 15 may also be surface-treated to be opaque. Therefore, the isolation columns 15 can not only transmit optical signals, but also can effectively avoid interference of other light on the optical signals. For example, the isolation columns 15 can prevent light emitted by adjacent pixel points from interfering with the optical signals, and effectively improve the optical signal-to-noise ratios.

Specifically, in an embodiment, the outer side surfaces 151 of the isolation columns 15 are surface-treated by at least one of coating an opaque coating and attaching an opaque film. Therefore, the isolation columns 15 can not only transmit optical signals, but also can effectively avoid interference of other light on the optical signals. For example, the isolation columns 15 can prevent the light emitted by the adjacent pixel points from interfering with the optical signals, effectively improve the optical signal-to-noise ratios, and reduce difficulty of manufacturing processes.

Furthermore, in an embodiment, the interior defined by the outer side surface 151, the first end surface 153, and the second end surface 155 is solid and made of a light-transmitting material.

It can be understood that in a modified embodiment, a part of the interior defined by the outer side surface 151, the first end surface 153, and the second end surface 155 is solid and made of a light-transmitting material, and the other part is a hollow structure. Therefore, optical signals can be transmitted, a material can be saved, and a cost and weight can be reduced.

Furthermore, in an embodiment, each of the isolation columns 15 is shaped as one of a rectangular parallelepiped, a cylinder, a trapezoidal body, a truncated cone, and a truncated cone, or a combination of two or more of them, and can be shaped according to actual needs, and is not limited herein.

Furthermore, in an embodiment, at least one of the first end surface 153 and the second end surface 155 of each of the isolation columns 15 is provided with an anti-reflection film.

Furthermore, in an embodiment, an end of each of the isolation columns 15 is accommodated in one of the gaps 137, and another end is disposed in the substrate 11. Because a height of the isolation columns 15 is increased, the isolation columns 15 can further prevent the light emitted by the adjacent pixel points from interfering with the optical signals transmitted through the isolation columns 15, thereby further improving the optical signal-to-noise ratios.

Furthermore, in an embodiment, an end of each of the isolation columns 15 is accommodated in one of the gaps 137, and another end is disposed on a side of the substrate 11 away from the first electrode 12. Because the height of the isolation columns 15 is further increased, the isolation columns 15 can further prevent the light emitted by the adjacent pixel points from interfering with the optical signals transmitted through the isolation columns 15, thereby further improving the optical signal-to-noise ratios.

Furthermore, in an embodiment, the OLED pixel structure 1 further comprises an insulating layer 17. The insulating layer 17 is disposed in the gaps 137 and between any two of the adjacent pixel points, and is attached to the substrate 11. The isolation columns 15 penetrate through the insulating layer 17. Therefore, the insulating layer 17 can electrically insulate any two adjacent pixels from each other.

Furthermore, in an embodiment, the OLED pixel structure 1 further comprises a light-shielding layer 18. The insulating layer 17 is disposed in the gaps 137, is attached to the insulating layer 17, and surrounding the isolation columns 15. The light-shielding layer 18 can further prevent the light emitted by the pixel points close to the isolation columns 15 from interfering with the optical signals transmitted through the isolation columns 15, thereby effectively improving the optical signal-to-noise ratios.

Furthermore, in an embodiment, the pixel points comprise a plurality of red (R) pixel points 131, a plurality of green (G) pixel points 133, and a plurality of blue (B) pixel points 135 disposed in an array, and any two adjacent pixel points of the R pixel points 131, the G pixel points 133, and the B pixel points 135 cooperatively define one of the gaps 137 therebetween. That is, the R pixel point 131 and the G pixel point 133 adjacent to each other cooperatively define one of the gaps 137. The G pixel point 131 and the B pixel point 133 adjacent to each other cooperatively define another gap 137. The B pixel point 133 and the R pixel point 131 of the next OLED pixel structure 1 adjacent to each other cooperatively define further another gap 137.

Each of the isolation columns 15 is partially accommodated in one of the gaps 137. Therefore, the isolation columns 15 can effectively prevent light emitted by the R pixel points 131, the G pixel points 133, and/or the B pixel points 135 from interfering with the optical signals transmitted through the isolation columns 15, thereby effectively improving the optical signal-to-noise ratios.

Furthermore, in an embodiment, the R pixel points 131, the G pixel points 133, and the B pixel points 135 are respectively formed of red, green, and blue light-emitting materials that emit light independently. It can be understood that, in a modified embodiment, the R pixel points 131, the G pixel points 133, and the B pixel points 135 are respectively formed of color filters used in combination with a white backlight. In another modified embodiment, the R pixel points 131, the G pixel points 133, and the B pixel points 135 are respectively formed of color conversion layers used in combination with a blue light source.

Furthermore, the OLED display screen 10 further comprises a cover plate 16. The cover plate 16 is disposed on a side of the substrate 11 away from the pixel layer 13. It can be understood that, in an embodiment, the cover plate 16 is a glass cover plate. In a modified embodiment, the cover plate 16 may be a cover plate made of other materials, which is not limited herein.

In a modified embodiment, an end of each of the isolation columns 15 is disposed in one of the gaps 137, and another end is disposed in the cover plate 16. Because the height of the isolation columns 15 is further increased, the isolation columns 15 can further prevent the light emitted by the R pixel points 131, the G pixel points 133, and the B pixel points 135 from interfering with the optical signals transmitted through the isolation columns 15, thereby effectively improving the optical signal-to-noise ratios.

Furthermore, the OLED display screen 10 further comprises films disposed between the cover plate 16 and the substrate 11. It can be understood that the films comprise, but are not limited to, a polarizer and the like.

Furthermore, in an embodiment, the OLED display screen 10 further comprises a bottom plate. The bottom plate is disposed on a side of the second electrode 14 away from the first electrode 12. The isolation columns 15 penetrate through the bottom plate. It can be understood that, in an embodiment, the bottom plate is a glass bottom plate. In a modified embodiment, the bottom plate may be a cover plate made of other materials, which is not limited herein.

Furthermore, the electronic device 100 further comprises optical sensors 2. The optical sensors 2 are disposed on sides of the isolation columns 15 away from the substrate 11. The optical sensors 2 are configured to receive the optical signals transmitted through the isolation columns 15 and convert the optical signals into electrical signals.

Furthermore, the electronic device 100 further comprises a processor 20. The processor 20 is electrically connected to the optical sensors 2. The processor 10 may be a central processing unit (CPU), and may also be a general-purpose processor, a digital signal processor (DSP), an application-specific integrated circuit (ASIC), a field-programmable gate array (FPGA) or another programmable logic device, a discrete gate or transistor logic device, a discrete hardware device, and the like. The general-purpose processor may be a microprocessor. Alternatively, the general-purpose processor may also be any conventional processor. The processor 10 is a control center of the electronic device 100, and connects various parts of the entire electronic device 100 through various interfaces and lines. The processor 20 is configured to determine characteristic information carried by the optical signals according to the electrical signals. The characteristic information may be fingerprint information, light intensity information of ambient light, distance information between a target object and the electronic device 100, and the like.

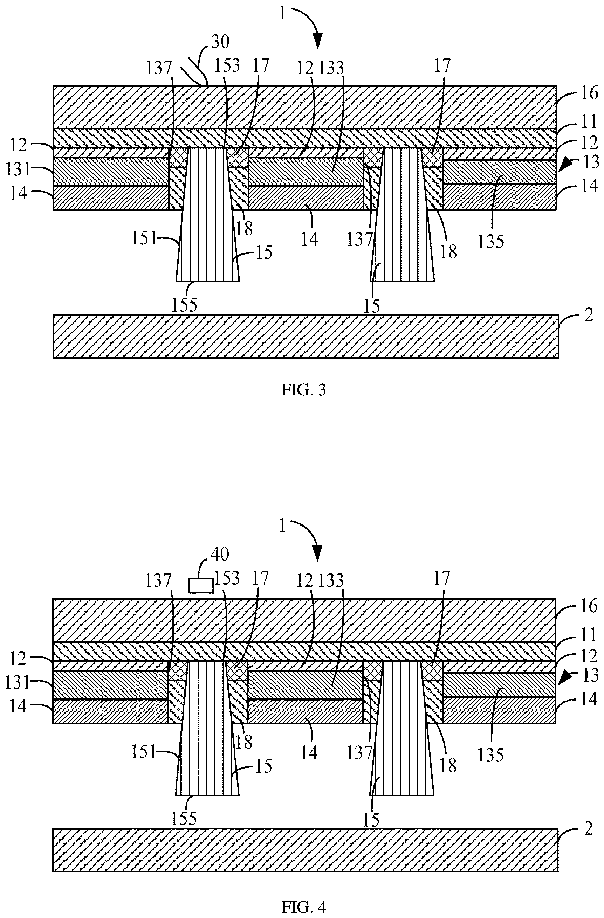

Please refer to FIG. 3. In an embodiment, the optical sensors 2 comprise under-screen fingerprint sensors. When a finger touches the OLED display screen 10, light emitted by the OLED display screen 10 penetrates through the substrate 11 and illuminates a fingerprint texture of the finger 30. The light is reflected by the fingerprint texture to form a reflected optical signal, and the reflected optical signal penetrates through the OLED display screen 10. The isolation columns 15 are further configured to transmit the reflected optical signal to the under-screen fingerprint sensors. The under-screen fingerprint sensors are configured to receive the reflected optical signal and convert the reflected optical signal into an electrical signal. The processor is configured to form a fingerprint image according to strength of the electrical signal to identify the fingerprint.

It can be understood that in a modified embodiment, the optical sensors 2 comprise under-screen optical sensors. The isolation columns 15 of the OLED display screen 10 are further configured to transmit an ambient light signal to the under-screen optical sensors, and the ambient light signal illuminates the under-screen optical sensors. The under-screen optical sensors are configured to receive the ambient light signal and convert the ambient light signal into an electrical signal, and is configured to identify a light intensity of the ambient light signal according to strength of the electrical signal.

Please refer to FIG. 4. In another modified embodiment, the optical sensors 2 comprise under-screen proximity sensors. The isolation columns 15 are further configured to transmit infrared light emitted by the under-screen proximity sensors to an outside of the electronic device 100, and the infrared light is reflected by a target object 40 to form a reflected optical signal. The isolation columns are further configured to transmit the reflected optical signal to the under-screen proximity sensors. The under-screen optical sensors are configured to receive the reflected optical signal and convert the reflected optical signal into an electrical signal, and is configured to identify a distance between the target object 40 and the OLED display screen 10 according to strength of the electrical signal.

Accordingly, in the OLED pixel structure, the OLED display screen, and the electronic device of the present disclosure, each of the isolation columns 15 of the OLED pixel structure 1 comprises the first end surface 153 and the second end surface 155 disposed oppositely. Each of the isolation columns 15 is configured to transmit optical signals and allow the optical signals to pass in from one of the first end surface 153 and the second end surface 155 and pass out from the other end surface, thereby guiding the optical signals to the optical sensors 2. The optical sensors 2 are configured to receive the optical signals transmitted through the isolation columns 15 and convert the optical signals into electrical signals. The processor 20 is configured to determine characteristic information carried by the optical signals according to the electrical signals. Therefore, optical signal interference caused by other light can be effectively prevented, and optical signal-to-noise ratios can be effectively improved.

The above are implementations of the embodiments of the present disclosure. It should be noted that those skilled in the art can make various improvements and modifications without departing from the principles of the embodiments of the present disclosure, and these improvements and modifications also fall within the claimed scope of the present disclosure.

## Claims

1. An organic light-emitting diode ,OLED, pixel structure, comprising:
a substrate;
a first electrode disposed on the substrate;
a pixel layer disposed on the first electrode, wherein the pixel layer comprises a plurality of pixel points disposed in an array, and two adjacent pixel points cooperatively define a gap therebetween;
a second electrode disposed on the pixel layer, wherein parts of the first electrode and the second electrode corresponding to the gap are hollowed out; and
an isolation column, wherein a part of the isolation column is accommodated in the gap, the isolation column comprises a first end surface and a second end surface disposed oppositely, the first end surface faces the substrate, the second end surface faces away from the substrate, and the isolation column is configured to transmit an optical signal and allow the optical signal to pass in from one of the first end surface and the second end surface, and pass out from the other end surface.

2. The OLED pixel structure as claimed in claim 1, **characterized in that** the isolation column further comprises an outer side surface disposed along a periphery of the isolation column, the outer side surface connects the first end surface and the second end surface, the outer side surface of the isolation column is opaque, and an interior, the first end surface, and the second end surface of the isolation column are transparent.

3. The OLED pixel structure as claimed in claim 2, **characterized in that** the outer side surface of the isolation column is surface-treated to be opaque.

4. The OLED pixel structure as claimed in claim 3, **characterized in that** the outer side surface of the isolation column is surface-treated by at least one of coating an opaque coating and attaching an opaque film.

5. The OLED pixel structure as claimed in claim 2, **characterized in that** the interior defined by the outer side surface, the first end surface, and the second end surface is solid and made of a light-transmitting material.

6. The OLED pixel structure as claimed in claim 2, **characterized in that** a part of the interior defined by the outer side surface, the first end surface, and the second end surface is solid and made of a light-transmitting material, and the other part is a hollow structure.

7. The OLED pixel structure as claimed in claim 1, **characterized in that** at least one of the first end surface and the second end surface of the isolation column is provided with an anti-reflection film.

8. The OLED pixel structure as claimed in claim 1, **characterized in that** the isolation column is shaped as one of a rectangular parallelepiped, a cylinder, a trapezoidal body, a truncated cone, and a truncated cone, or a combination of two or more of them.

9. The OLED pixel structure as claimed in claim 1, **characterized in that** an end of the isolation column is accommodated in the gap, and another end is disposed in the substrate.

10. The OLED pixel structure as claimed in claim 1, **characterized in that** an end of the isolation column is accommodated in the gap, and another end is disposed on a side of the substrate away from the first electrode.

11. The OLED pixel structure as claimed in claim 1, further comprising:
an insulating layer disposed in the gap and between two the adjacent pixel points and attached to the substrate, wherein the isolation column penetrates through the insulating layer.

12. The OLED pixel structure as claimed in claim 11, further comprising:
a light-shielding layer disposed in the gap, attached to the insulating layer, and surrounding the isolation column.

13. The OLED pixel structure as claimed in one of claims 1-12, **characterized in that** the pixel points comprise a plurality of red (R) pixel points, a plurality of green (G) pixel points, and a plurality of blue (B) pixel points disposed in an array, and two adjacent pixel points of the R pixel points, the G pixel points, and the B pixel points cooperatively define the gap therebetween.

14. An organic light-emitting diode ,OLED, display screen, comprising:
the OLED pixel structure as claimed in one of claims 1-13; and
a cover plate disposed on a side of the substrate away from the pixel layer.

15. The OLED display screen as claimed in claim 14, **characterized in that** an end of the isolation column is disposed in the gap, and another end is disposed in the cover plate.

16. The OLED display screen as claimed in claim 14, further comprising:
a bottom plate disposed on a side of the second electrode away from the first electrode, wherein the isolation column penetrates through the bottom plate.

17. An electronic device, comprising:
the organic light-emitting diode ,OLED, display screen as claimed in one of claims 14-16;
an optical sensor disposed on a side of the isolation column away from the substrate, wherein the isolation column is further configured to guide the optical signal to the optical sensor, and the optical sensor is configured to receive the optical signal transmitted through the isolation column and convert the optical signal into an electrical signal; and
a processor configured to determine characteristic information carried by the optical signal according to the electrical signal.

18. The electronic device as claimed in claim 17, **characterized in that**
the optical sensor comprises an under-screen fingerprint sensor;
when a finger touches the OLED display screen, light emitted by the OLED display screen penetrates through the substrate and illuminates a fingerprint texture of the finger;
the light is reflected by the fingerprint texture to form a reflected optical signal, and the reflected optical signal penetrates through the OLED display screen;
the isolation column is further configured to transmit the reflected optical signal to the under-screen fingerprint sensor;
the under-screen fingerprint sensor is configured to receive the reflected optical signal and convert the reflected optical signal into an electrical signal; and
the processor is configured to form a fingerprint image according to strength of the electrical signal to identify the fingerprint.

19. The electronic device as claimed in claim 17, **characterized in that**
the optical sensor comprises an under-screen optical sensor;
the isolation column of the OLED display screen is further configured to transmit an ambient light signal to the under-screen optical sensor, and the ambient light signal illuminates the under-screen optical sensor; and
the under-screen optical sensor is configured to receive the ambient light signal and convert the ambient light signal into an electrical signal, and is configured to identify a light intensity of the ambient light signal according to strength of the electrical signal.

20. The electronic device as claimed in claim 17, **characterized in that**
the optical sensor comprises an under-screen proximity sensor;
the isolation column is further configured to transmit infrared light emitted by the under-screen proximity sensor to an outside of the electronic device, and the infrared light is reflected by a target object to form a reflected optical signal;
the isolation column is further configured to transmit the reflected optical signal to the under-screen proximity sensor; and
the under-screen optical sensor is configured to receive the reflected optical signal and convert the reflected optical signal into an electrical signal, and is configured to identify a distance between the target object and the OLED display screen according to strength of the electrical signal.
